# EUROPEAN PATENT APPLICATION

(11) **EP 4 446 460 A1**
(43) Date of publication of application: **16.10.2024**
(21) Application number: 23167253.6
(22) Date of filing: 11.04.2023
(51) Int. Cl.: C23C 14/56, C23C 16/54, H01J 37/32

(54) **VACUUM COATING SYSTEM**

(71) Applicant: NEOVAC GmbH, 63791 Karlstein (DE)
(72) Inventor: SCHNEIDER, Stefan, 63791 Karlstein (DE); HERZOG, André, 63791 Karlstein (DE)
(74) Representative: Weilnau, Carsten

(57) **Abstract**

The present disclosure relates to a vacuum coating system for coating a band-type substrate (5), the vacuum coating system (10) comprising:
- a first module (20) comprising a first module housing (21), the first module housing (21) comprising at least one of a first substrate inlet (22) and a first substrate outlet (23),
a second module (40) comprising a second module housing (41), the second module housing (41) comprising at least one of a second substrate inlet (42) and a second substrate outlet (43),
- a substrate transportation unit (50) provided in one of the first module housing (21) and the second module housing (41) and
- a substrate treatment unit (60) provided in the other one of the first module housing (21) and the second module housing (41),
- wherein at least one of the substrate transportation unit (50) and the substrate treatment unit (70) is interchangeably arranged in one of the first module housing (21) and the second module housing (41), or
- wherein the first module (20) and the second module (40) are interchangeably connectable via at least one of the first and second substrate inlets (22, 42) and at least one of the first and second substrate outlets (23, 43), respectively.

## Description

The present invention relates to the field of coating substrates and in particular to the field of coating metallic substrates with a metallic coating or with an anti-corrosive coating. Aspects of the present invention relate to a vacuum coating system and to a method of configuring a vacuum coating system.

### Background

There exist various approaches to plating or coating a surface of a corrosive material, such as a strip or band of steel with an anti-corrosive material, such as a zinc, aluminum or the like. It is generally known to coat the surface of a corrosive metallic material with an anti-corrosive coating, e.g. by electro galvanizing, hot-dip galvanization or by way of physical vapor deposition (PVD).

For instance, document US 2021/0238726 A1 discloses a vacuum coating system for coating a band-type material, in particular a sheet or strip of metal.

Generally, such vacuum coating systems are designed for only one specific coating or surface treatment process. The overall design and operation of the vacuum coating system may be limited to supports only a single well-defined vacuum deposition or vacuum treatment procedure with the band-type material. Modifications to the process of substrate treatment or modifications to a coating or treatment procedure require a rather elaborate reconfiguration or retrofitting of the entire coating system. Moreover, the overall footprint or space required for the installation of such vacuum coating systems is comparatively large and is difficult to modify. Variations or modifications of a coating or treatment process may require an elaborate reinstallation of the coating system. Such modifications of the coating or substrate treatment process may therefore quite often imply a complete redesign or restructuring of the equipment or of the entire vacuum coating system.

It is therefore desirable to provide improvements to vacuum coating systems that allow for a rather flexible and easy configuration as well as reconfiguration in order to adapt the vacuum coating system to different or varying demands for a substrate coating or substrate treatment process.

### Summary

The above-described problems and deficiencies are solved by a vacuum coating system for coating a band-type substrate as well as by a method of configuring or reconfiguring a vacuum coating system in accordance to the definition of the independent claims. Numerous examples and embodiments are subject matter of respective dependent claims.

In one aspect there is provided a vacuum coating system for coating a band-type substrate. The vacuum coating system comprises a first module. The first module comprises a first module housing. The first module housing comprises at least one of a first substrate inlet and a first substrate outlet. The vacuum coating system further comprises a second module. The second module comprises a second module housing. The second module housing comprises at least one of a second substrate inlet and a second substrate outlet.

The vacuum coating system further comprises a substrate transportation unit provided in one of the first module housing and the second module housing. The vacuum coating system further comprises a substrate treatment unit provided in the other one of the first module housing and the second module housing. By way of the substrate transportation unit the band-type or strip-type substrate can be transported through at least one of the first and second modules or through the assembly of first and second modules. By way of the substrate treatment unit at least a surface of the substrate can be treated in accordance to a process to be executed by the vacuum coating system. For instance, the substrate treatment unit may serve to prepare, to coat the substrate with a coating or with a layer of material or to otherwise treat, e.g. to anneal the substrate.

At least one of the substrate transportation unit and the substrate treatment unit is interchangeably or detachably arranged in one of the first module housing and the second module housing. Alternatively or additionally, the first module and the second modules are interchangeably connectable via at least one of the first and second substrate inlets and at least one of the first and the second substrate outlets, respectively.

By providing first and second modules with first and second module housings, respectively and by providing at least one of a substrate transportation unit and at least one of a substrate treatment unit there is provided an interchangeable and hence reconfigurable arrangement of a substrate transportation unit and a substrate treatment unit with different modules or module housings. The module housings may comprise a well-defined and fixed geometric structure. By interchangeably arranging or fastening the transportation unit and/or the treatment unit to one of the first and second module housings the overall design of the vacuum coating system can be changed and reconfigured accordingly.

Moreover, by interchangeably arranging at least one of the substrate transportation unit and the substrate treatment unit in one of the first and second module the respective module housings and hence the respective modules can be modified and reconfigured between a substrate transportation module, which serves to provide a transportation of the substrate through the respective or through adjacently located modules and a substrate treatment module, which is primarily operable to treat, i.e. to prepare and/or to coat the surface of the substrate.

In some examples the first module housing and the second module housing may be fixed relative to each other. Here, and by interchangeably arranging of fastening the substrate transportation unit and/or the substrate treatment unit to or inside one of the first module housing and/or the second module housing the role of respective first and second module housings can be changed, namely by removing a substrate transportation unit e.g. from the first module housing and by arranging the substrate transportation unit in the second module housing. Vice versa, a substrate treatment unit, initially provided in the first module housing may be removed from the first module housing and may be arranged inside the second module housing. In this way, the role and functionality of first and second modules can be swapped or modified simply by exchanging or reconfiguring the arrangement of the substrate transportation unit and/or the substrate treatment unit in the first and second module housings, respectively.

In another example it is also conceivable to provide numerous treatment units that distinguish by the type of a substrate treatment or to provide numerous transportation units that distinguish by a type of transportation. Here, and when starting from an initial configuration, wherein a first treatment unit is arranged in a first module housing the respective module can be reconfigured towards a modified configuration, e.g. by exchanging the first treatment unit by a second treatment unit and/or by exchanging a first transportation unit by a second transportation unit. This way, a module housing can be individually and variably equipped with one of a large variety of treatment units or transportation units to set up or to configure a vacuum coating system.

By way of example, and when the first module with its first module housing is equipped with a substrate treatment unit the respective module forms or constitutes a substrate treatment module. Arranging a substrate transportation unit in the first module housing transforms the respective module into a transportation module. Accordingly, one and the same housing, e.g. one of the first module housing and the second module housing may be arbitrarily used to form or to constitute one of a transportation module and a substrate treatment module by receiving and accommodating a respective substrate treatment unit or substrate transportation unit. In this way, the total number of differently configured or differently sized module housings can be reduced to a minimum, thus allowing to reduce costs and expenditure for a design and redesign of such vacuum coating systems.

Moreover and according to further examples it is conceivable that the substrate transportation unit is provided in the first module housing and that the substrate treatment unit is provided in the second module housing. Here and by interchangeably connecting the first module housing and the second module housing, the position of respective module housings equipped with the transportation unit and the treatment unit can be swapped or reconfigured, thus allowing for a rather easy and flexible reconfiguration of the entire vacuum coating system.

Of course, the vacuum coating system may not only comprise a first module and a second module but may comprise numerous modules, typically arranged in a row or column so as to define a path along which the band-type substrate is transported and along which the substrate can be surface treated.

The vacuum coating system may be divided into a number of modules, some of which being dedicated to the transportation of the substrate through the arrangement of modules and some of which being specifically dedicated to the treatment of the substrate. In some examples, the modules are exclusively equipped with a substrate transportation unit and some modules are exclusively equipped with a substrate treatment unit for substrate treatment.

In some examples, one of the first module and the second module may be provided with both, a substrate treatment unit and with a substrate transportation unit. Here, the module fulfills or comprises a two-fold functionality, namely to provide a transportation of the substrate through the respective module housing and to provide a treatment of the surface of the substrate.

In some examples, the module housings comprise standardized connectors or fasteners to detachably receive or to detachably connect at least one of the substrate treatment unit and the substrate transportation unit. A fastening structure of the module housings for fastening of a substrate transportation unit may be equal to the fastening structure configured for fastening of a substrate treatment unit; and vice versa. Hence, the substrate transportation unit and the substrate treatment unit may comprise equal or at least mutually corresponding fastening structures by way of which they are interchangeably fastenable to or inside the first module housing and the second module housing, respectively. Moreover, the first module housing and the second module housing may comprise identical mechanical fasteners for fastening the substrate transportation unit and/or for fastening the substrate treatment unit inside the module housing.

Standardized connectors and fastening structures as provided on or inside the first and the second module housings allow to interchangeably arrange and/or to interchangeably fasten the substrate transportation unit and the substrate treatment unit in any of the first module housing and the second module housing.

Moreover and according to further examples, the first module and the second module are interchangeably connectable via at least one of the first and second substrate inlets and/or via at least one of the first and second substrate outlets, respectively. Hence, in one configuration the first substrate outlet of the first module may be connected with the second substrate inlet of the second module. In another configuration the order and hence the sequence of the first and second modules, e.g. equipped with different substrate transportation units and/or with different substrate treatment units, may be changed or interchanged. Then, a second substrate outlet of the second module may be connected or interconnected with the first substrate inlet of the first module. The interchangeable connectivity between first and second modules, i.e. between first and second module housings is of particular benefit to rearrange existing and e.g. preconfigured modules of the vacuum coating system.

According to a further example the vacuum coating system is transferable between a first operating configuration and at least one of a second operating configuration and a third operating configuration. In some examples the vacuum coating system is transferable between the first operating configuration, the second operating configuration and the third operating configuration. In the first operating configuration, the first substrate outlet is directly or indirectly connected with the second substrate inlet. In the second operating configuration the second substrate outlet is directly or indirectly connected with the first substrate inlet. In the third operating configuration, the first substrate outlet is directly connected with a third substrate inlet of a third substrate housing of a third module. In the first operating configuration the third substrate inlet is directly or indirectly connected with the second substrate outlet.

When starting from a first operating configuration the first substrate outlet is either directly or indirectly connected with the second substrate inlet. As seen along a sequence of process steps, the first module and hence the first module housing precedes the second module or second module housing. As the band-type substrate is subject to a treatment the substrate is transported through the first module towards the second module and through the second module. In the second operating configuration the roles of the first module and the second module may interchange. Here, the second module may precede the first module. Accordingly, the second substrate outlet of the second module is directly or indirectly connected with the first substrate inlet. Here, the substrate is transported along a transport direction through the second module and leaves the second module through the second substrate outlet and enters the first module through the first substrate inlet.

Transferring of the vacuum coating system from the first operating configuration into the second operating configuration implies that the first and second module housings are provided with mutually corresponding and/or with complementary shaped mechanical connecting structure and mechanical counter connecting structures, respectively.

In some examples, the first and second substrate inlets are provided with standardized mechanical connecting structures, which are complementary shaped to a counter connecting structure provided at the respective substrate outlet of the first and second modules. This allows for an interchangeable arrangement of first and second modules, i.e. first and second module housings, respectively.

In a third operating configuration the vacuum coating system comprises at least a first module, a second module and a third module. In the first operating configuration the second module is located between the first module and the third module. Accordingly, a second substrate inlet of the second module is directly connected with a first substrate outlet of the first module. The second substrate outlet of the second module is directly connected with a third substrate inlet as provided by the third module. In the first operating configuration the first module precedes the second module and the second module precedes the third module.

By transferring the vacuum coating system from the first configuration into the third configuration it may be only required to remove the second module. Then, the first substrate outlet of the first module is directly connected to the third substrate inlet of the third module. In other words, by transferring the vacuum coating system between the first configuration and the third configuration the total number of modules constituting the vacuum coating system changes. Nonetheless and since the mechanical connecting structures and mechanical counter connecting structures, e.g. in the region of respective substrate inlets and substrate outlets of the modules, are substantially of equal or complementary shape or structure, such reconfigurations can be implemented in a rather straightforward and uncomplicated manner.

This allows to reconfigure the vacuum coating system not only with regards to the functionality and/or the order of individual vacuum coating modules but also to vary the total number of vacuum coating modules to comply with variations or reconfigurations of a coating or treatment process for the band-type substrate.

In some examples a module of the vacuum coating system may comprise only one of a substrate inlet and a substrate outlet. This particularly applies to so-called end or termination modules. Such end or termination modules may define the start and the end of the vacuum coating system as seen along a substrate transportation direction. One end module may be provided with a first coil on which the band-type substrate is coiled and from which the substrate is uncoiled for surface treatment in any of the following or subsequent modules. A second end or termination module provided at an opposite end of the vacuum coating system may be also provided with a coiler to wind up a treated, e.g. coated band-type substrate.

According to another example the first module housing comprises the first substrate inlet and the first substrate outlet. The same may apply to the second module housing, e.g. comprising the second substrate inlet and the second substrate outlet. Such first and/or second module housings may be transferred into an end or termination module housing e.g. by closing one of a substrate inlet and a substrate outlet. In this way, a rather generic module housing, e.g. provided with a first substrate inlet and with a first substrate outlet may be transferred into an end or termination module housing by closing and/or sealing one of the substrate inlet and the substrate outlet.

In particular, and when closing a substrate inlet the respective module may be transferred into a first end module, e.g. provided with a coiler to unwind the band-type substrate and to provide the band-type substrate through the first substrate outlet towards a following or subsequent module of the vacuum coating system. By closing a substrate outlet of a standardized or generic module housing there can be provided a second end or termination module, which is only equipped with a respective substrate inlet. Such a second end or termination module may be typically provided with a coiler operable to coil or to wind up the treated or coated band-type substrate.

In a further example and when the first module housing comprises the first substrate inlet and the first substrate outlet a first effective distance between the first substrate inlet and the first substrate outlet may be identical or equivalent to one of: i) a second effective distance between the second substrate inlet and the second substrate outlet of the second module housing and ii) an integer multiple n of a fraction f of the second effective distance, wherein f is one of: 1/2, 1/3, 1/4, 1/5, 1/6, 1/7 or 1/8 and wherein n is one of: 1, 2, 3, 4, 5, 6, 7, 8, 9, 10, 11, 12, 13, 14, 15 or 16.

Accordingly and by providing first and second module housings with first and second effective distances being equivalent to each other or defining a well-defined size ratio it is possible to change the order and/or the position of first and second modules in an existing vacuum coating system. Moreover, by defining the first effective distance as an integer multiple or as a fraction n/f of the second effective distance there is enabled a redesign or reconfiguration of a vacuum coating system, e.g. replacing two or a number of modules of a first configuration of the vacuum coating system by one or a different number of modules of the vacuum coating system in a second configuration.

The vacuum coating system may be provided with a predefined or well-defined grid dimension or module dimensions, which makes it possible to interchange or to replace individual modules by any other module and/or by replacing a number of modules n by a number of modules f, wherein n is unequal to f. Residual modules, that are not necessarily subject to a modification may then remain unchanged with regards to their relative and/or absolute position or configuration with a vacuum coating system, while transferring a vacuum coating system from a first configuration towards and into a second configuration.

Providing first and second module housings with a first and a second effective distance between respective substrate outlets and substrate inlets is of particular benefit to reconfigure the vacuum coating system and to replace a module by another module thereby leaving residual modules, which are not directly involved with the reconfiguration, substantially unchanged, both, in terms of their position and orientation in the first and the second configurations of the vacuum coating system.

According to a further example at least one of the first module housing and the second module housing comprises a first sidewall with a first through recess extending through the first sidewall and configured to receive a first substrate treatment unit there through. By providing the first sidewall with a first through recess the substrate treatment unit can be detachably and reconfigurably connected or arranged at or inside the first or second module housing. This allows for an interchangeable arrangement of different substrate treatment units to and/or inside one of the first module housing and the second module housing.

In some examples the substrate treatment unit or a variety of differently configured substrate treatment units may be fastened to the first sidewall and/or adjacent to the through recess. This allows for a rather easy installation and fastening of the substrate treatment unit to the sidewall and hence to or inside the respective module housing.

According to a further example at least one of the first module housing and the second module housing comprises a second sidewall with a second through recess extending through the second sidewall. The second through recess and/or the second sidewall is configured to receive a second substrate treatment unit therethrough. Here, the respective module housing may be configured for a double sided or two-sided simultaneous treatment of the band-type substrate extending through the respective module housing, e.g. from the respective substrate inlet to and/or through the respective substrate outlet.

In some examples and when the first or second module housings comprise first and second side walls with first and second through recesses the two sidewalls or through recess can be generally equipped with the same or identical substrate treatment units or with different substrate treatment units. In case of an identical configuration of first and second sidewalls or through recess with identical substrate treatment units there can be provided a two-sided and substantially equal surface treatment of the band-type substrate inside the respective first or second modules.

With first and second sidewalls with first and second through recesses equipped with different first and second substrate treatment units there can be provided different surface treatment processes on opposite sides of the band-type substrate. Here, a substrate treatment as provided by the first treatment unit may support or improve a process or substrate treatment provided or implemented by the second substrate unit.

According to a further example one of the first module housing and the second module housing comprises the first sidewall with the first through recess and the second sidewall with the second through recess. The first sidewall may be opposite to the second sidewall and/or the first through recess may be opposite to the second through recess.

In some examples the first and second through recesses may be directly opposite to each other. They may flush in a direction extending substantially perpendicular to the surface or plane of the band-type substrate, which is transported through the respective module housing from e.g. the first or second substrate inlet towards the first or second substrate outlet, respectively.

A direct and opposite arrangement and configuration of first and second through recesses and/or of first and second sidewalls is beneficial to provide equal or at least substantially equal process conditions on opposite sides of the substrate.

According to a further example the substrate treatment unit comprises a lid configured to close and/or to seal at least one of the first through recess and the second through recess. The lid may comprise a rather planar and stiff structure. It may be sized to entirely cover the through opening or through recess in at least one of the first sidewall and the second sidewall of the respective module housing. In this way and when arranging the treatment unit inside the respective module housing the lid may cover and/or close the through recess in the sidewall of the respective module housing.

With some examples the lid may be fastened, e.g. detachably fastened to the sidewall or sidewall portion comprising the through recess. The substrate treatment unit may be rigidly attached or rigid connected to the lid. In this way, the substrate treatment unit may be arranged and/or detachably fastened and fixed to the first or second module housing simply by attaching and fastening the respective lid of the substrate treatment unit to the sidewall of the module housing.

Here, a border region of the through recess of the first or second sidewall may be provided with a fastening structure complementary shaped to a counter fastening structure of the respective substrate treatment unit.

According to a further example the substrate treatment unit comprises one of an evaporator, a magnetron, a plasma source, a heating unit and a cooling unit. Hence, the substrate treatment unit may be operable to modify the temperature of the substrate. In further examples the substrate treatment unit may be configured to generate a plasma inside the respective module housing by way of which a coating or layer of material can be deposited on the surface of the band-type substrate, e.g. by way of physical vapor deposition (PVD).

In some examples of the vacuum coating system there are provided numerous substrate treatment units as described above. There may be provided one or numerous evaporators and/or one or numerous plasma sources as well as one or numerous heating units or one or numerous cooling units. Here, each module may be provided with a single substrate treatment unit or may be provided with numerous of the above-mentioned substrate treatment units. In this way, the vacuum coating system can be easily and reconfigurably adapted to varying demands of a treatment process for the band-type substrate.

According to a further example one of the first module and the second module is interchangeably provided with a first substrate treatment unit and wherein the first substrate treatment unit is replaceable by a second substrate treatment unit. Hence, the respective modules can be variably and reconfigurably provided with different substrate treatment units.

In other examples one and the same module, e.g. one of the first module and the second module may be provided with more than only one substrate treatment unit. Here, at least one of the first module and the second module may be provided with a first substrate treatment unit and with a second substrate treatment unit or even with a third substrate treatment unit. In this way and by providing a module with a number of equal or with a number of different substrate treatment units the operability and a functionality of the respective module can be modified in principle.

According to a further example the substrate transportation unit comprises one of a transport roller, a deflection roller, a tensioning roller and a coiler. The coiler and the above-mentioned roller may be passively or actively driven, e.g. by a drive.

By way of a transport roller the band-type substrate may be transported linearly through the respective module or module housing, e.g. in a rather straight and/or undeflected configuration. With a deflection roller the band-type substrate may change its transportation direction inside a respective module, which is equipped with the deflection roller. The deflection roller is may provide a reorientation or redirection and hence a bending or deflection of the transport direction of the band-type substrate, e.g. by about 90°, by about 60°, by about 45° or by about 30°.

Specifically, and with modules being equipped or configured as transportation modules and being provided with a deflection roller, a substrate inlet may not be provided opposite to a substrate outlet. Rather and e.g. with a deflection roller providing a deflection of the substrate transport direction by e.g. a 90° the substrate inlet may be provided in a third sidewall and a substrate outlet may be provided in a fourth sidewall, wherein the third sidewall is not opposite but is adjacent to the fourth sidewall. This may particularly apply in a rectangularly shaped module housing or in a module housing of cuboidic shape.

According to a further example at least one of the first module housing and the second module housing comprises a third sidewall and a fourth sidewall. The third sidewall is provided with one of the first substrate inlet and the second substrate inlet and the fourth sidewall is provided with one of the first substrate outlet and the second substrate outlet. In some examples the module housings of first and second modules are of cuboidic or rectangular shape. Here, and as seen in a direction transverse to the transportation direction of the substrate first and second sidewalls may be provided opposite to each other. Also, third and fourth sidewalls may be provided opposite to each other. In some examples, a third sidewall is located between first and second sidewalls and the fourth sidewall may be provided between an opposite end of first and second sidewalls.

However and specifically with substrate transportation units comprising a deflection roller third and fourth sidewalls may not necessarily located opposite to each other. They may be arranged adjacently to each other and may each comprise a surface normal extending at an angle between 30° and 60° relative to each other.

According to a further example the third sidewall is opposite to the fourth sidewall and/or the third substrate inlet is opposite to the first substrate outlet and/or the second substrate inlet is opposite to the second substrate outlet. In either way, and when the third sidewall is opposite to the fourth sidewall and when the third sidewall is provided with the substrate inlet and when the fourth side wall is provided with a substrate outlet, the respective module provides and/or supports a rather straight and hence undeflected substrate transportation from the substrate inlet towards and through the substrate outlet.

The first and second sidewalls may comprise a surface normal that is substantially parallel to a surface normal of the band-type substrate transported through the respective module or module housing. The first and/or the second through recesses provided in first and second sidewalls of a respective housing therefore face towards a surface of the band-type substrate that should be treated, e.g. coated with the vacuum coating system.

In a further example the third sidewall is adjacent to or adjoins the fourth sidewall. At least one of the first substrate inlet and the second substrate inlet extends at a predefined angle relative to the first substrate outlet and the second substrate outlet of the same module housing. Such examples particularly apply where the respective module or module housing is equipped with a transportation unit that provides a deflection or redirection of the band-type substrate inside the respective module housing.

With a deflection roller, e.g. redirecting the substrate transportation direction by 90° the substrate inlet may extend at an angle of about 90° to the substrate outlet of the same module housing. In other examples and wherein the deflection roller defines a redirection or deflection of the substrate transportation direction e.g. by about 30° or by about 45° the substrate inlet and the associated substrate outlet of the same module housing may extend at a respective angle relative to each other in order to provide a respective transportation of the substrate through the module housing.

In a further example the first module housing comprises a first mechanical connecting structure at the first substrate inlet and further comprises a first mechanical counter connecting structure at the first substrate outlet. The second module housing comprises a second mechanical connecting structure at the second substrate inlet and further comprises a second mechanical counter connecting structure at the second substrate outlet. Here, the first mechanical connecting structure is complementary shaped to at least one of the first mechanical counter connecting structure, the second mechanical connecting structure and the second counter connecting structure. In this way, there can be provided a well-defined and reconfigurable mechanical fastening of first and second module housings via their respective mechanical connecting structures and mechanical counter connecting structures.

In some examples the second mechanical connecting structure may be substantially identical to the first mechanical connecting structure. Likewise, the second mechanical counter connecting structure may be identical to the first mechanical counter connecting structure. In this way, the first substrate outlet of the first module housing equipped with the first mechanical counter connecting structure can be connected with the second connecting structure at the second substrate inlet of the second module housing. Likewise, the second substrate outlet of the second module housing and provided with the second mechanical counter connecting structure may be detachably connectable with the first mechanical connecting structure provided at the first substrate inlet of the first module housing. In this way, the order or sequence of first and second module housings can the interchanged on demand.

In another example at least one of the first module housing and the second module housing is alignable in one of a horizontal orientation and a vertical orientation. When in the horizontal orientation the substrate inlet is separated from the substrate outlet along a horizontal direction. When in the vertical orientation the substrate inlet is separated from the substrate outlet along a vertical direction.

In some examples there may be provided various modules for arrangement in different orientations, e.g. in or along the horizontal orientation and/or in or along the vertical orientation or direction.

With other examples the first module and/or the second module may be arrangeable in either orientation. Here, the first module or the first module housing may be configured for use in a horizontal orientation as well as in a vertical orientation. It may be universally usable in different orientations and may the reconfigurable and/or connectable or attachable to adjacently located modules to establish or to contribute to the reconfigurable vacuum coating system.

According to a further example the vacuum coating system is configured for coating a band-type metallic substrate, such as a steel, with a metallic material or metallic alloy comprising at least one or a combination of at least one or more of the following materials: zinc, aluminum, nickel, chrome, magnesium or titanium, e.g. by way of physical vapor deposition (PVD).

According to another aspect the present disclosure also relates to a method of configuring or reconfiguring a vacuum coating system as described above. Here, the method comprises the steps of providing a first module housing and a second module housing and providing a substrate transportation unit and a substrate treatment unit. The method of configuring or reconfiguring the vacuum coating system comprises to interchangeably arrange the substrate transportation unit in one of the first module housing of the second module housing and to interchangeably arrange the substrate treatment unit in the other one of the first module housing and the second module housing. Alternatively, the method comprises the step of interchangeable connecting the first module and the second module by at least one of the first and second substrate inlets and at least one of the first and second substrate outlets, respectively. Here, the first module may be equipped with one of the substrate transportation unit and the substrate treatment unit and the second module may be equipped with the other one of the substrate transportation unit and the substrate treatment unit.

It is to be noted that the method of configuring or reconfiguring the vacuum coating system is particularly implementable with a vacuum coating system as described above. Insofar, all effects, features and benefits as described above in connection with the vacuum coating system equally apply to the method of configuring the vacuum coating system; and vice versa.

### Brief Description of the Drawings

In the following, numerous examples of the vacuum coating system and components thereof such as individual modules, and a method of configuring or reconfiguring a vacuum coating system are described in greater detail by making reference to the drawings, in which:
- Fig. 1: schematically illustrates an example of a vacuum coating system for coating a band-type substrate,
- Fig. 2: shows another example of a vacuum coating system,
- Fig. 3: shows an example of a module of a vacuum coating system,
- Fig. 4: schematically illustrates another configuration of a module for use in the vacuum coating system,
- Fig. 5: schematically illustrates a treatment unit implemented as an evaporator,
- Fig. 6: shows another example of an evaporator,
- Fig. 7: shows a further example of an evaporator,
- Fig. 8: shows an example of another treatment unit implemented as a magnetron,
- Fig. 9: shows another example of a treatment unit implemented as a plasma source,
- Fig. 10: schematically illustrates another example of a treatment unit for arrangement inside one of the modules of the vacuum coating system,
- Fig. 11: shows another example of a treatment unit implemented as a cooling unit,
- Fig. 12: shows an example of a transportation unit comprising numerous transport rollers,
- Fig. 13: shows another example of a transportation unit comprising a tensioning roller,
- Fig. 14: shows another example of a transportation unit comprising a deflection roller and
- Fig. 15: shows another example of a transportation unit comprising a coiler,
- Fig. 16: shows an example of a module housing,
- Fig. 17: shows another example of a module housing,
- Fig. 18: shows another example of a module housing,
- Fig. 19: shows another example of a module housing,
- Fig. 20: shows another example of a module housing,
- Fig. 21: shows another example of a module housing,
- Fig. 22: shows another example of a module housing,
- Fig. 23: shows another example of a module housing,
- Fig. 24: shows another example of a module housing,
- Fig. 25: shows another example of a module housing,
- Fig. 26: shows another example of a module housing,
- Fig. 27: shows another example of a module housing,
- Fig. 28: shows an example of a connecting and a counter connecting structure of first and second modules,
- Fig. 29: shows further details of the mutually corresponding connecting and counter connecting structures of adjacently located module housings,
- Fig. 30: shows a first configuration of a vacuum coating system,
- Fig. 31: shows a second configuration of a vacuum coating system,
- Fig. 32: shows a third configuration of the vacuum coating system and
- Fig. 33: shows a flowchart of a method of configuring a vacuum coating system.

### Detailed description

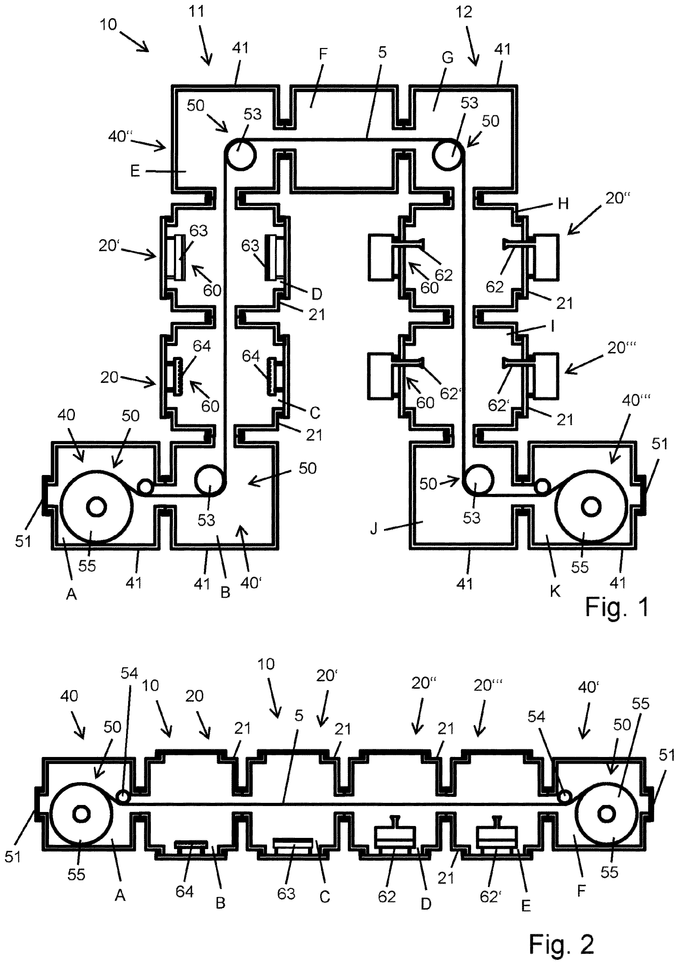

In Figs. 1 and 2 there are illustrated two different configurations or examples of a vacuum coating system 10 according to the present invention. The vacuum coating system comprises numerous modules 20, 40 which define a substrate transportation path extending through the arrangement of numerous modules. The vacuum coating system 10 according to Fig. 1, comprises numerous modules A, B, C, D, E, F, G, H, I, J, K which are arranged in series. The entire vacuum coating system 10 is constituted by an arrangement of these individual modules, each of which being either equipped with at least one of a substrate transportation unit 50 and a substrate treatment unit 60.

In the example according to Fig. 1 there is provided a module A implemented as a second module 40 and being equipped with a substrate transportation unit 50 in form of a coiler 55. The module A is connected with a further module B, which is in turn also implemented as a second module 40'. Here, a substrate outlet of module A is connected to a substrate inlet of module B. The module B is provided with another substrate transportation unit 50, which comprises a deflection roller 53. A further module C is connected with the module B and is implemented as e.g. substrate treatment module. A substrate outlet of module B is connected to a substrate inlet of module C. The module C may be implemented as a first module 20 comprising a first module housing 21 and being equipped with a substrate treatment unit 60, which may be implemented as a plasma source 64 or which may comprise a plasma source 64.

The module C is further connected with another module D. The module D is also implemented as a kind of a first module 20' and is also void of a transportation unit 50. It may comprise another substrate treatment unit 60, e.g. implemented as a magnetron 63. A substrate outlet of module C is connected to a substrate inlet of module D.

A substrate outlet of the module D may be directly connected with a substrate inlet of another module E. The module E may be implemented as another substrate transportation module and hence as a second module 40". It may be provided with another transportation unit 50, e.g. comprising a further deflection roller 53. A substrate outlet of the module E is connected with the substrate inlet of another module F. The module F may be implemented as a substrate transfer or substrate transportation module. It may be void of a substrate treatment unit. Alternatively, the module F may be equipped with a substrate treatment unit 60 and/or with a substrate transportation unit 50.

A substrate outlet of the module F is connected with the substrate inlet of another module G, which is also implemented as a substrate transportation module. The module G comprises a transportation unit 50, e.g. featuring a deflector roller 53. A substrate outlet of the module G is connected with a substrate inlet of another module H, which is implemented as another first module 20". The module H comprises a substrate treatment unit 60, e.g. comprising an evaporator 62. A substrate outlet of the module H is connected with a substrate inlet of a further module I, which is also implemented as a first module 20"'. The module I is equipped with another substrate treatment unit 60, e.g. implemented as another evaporator 62'.

A substrate outlet of the module I is connected with a substrate inlet of another module J, which is implemented as a substrate transportation module and which comprises another deflection roller 53. A substrate outlet of the module J is finally connected with a substrate inlet of a further module K, which is provided with a transportation unit 50 and which comprises another coiler 55.

The modules B, E, G, and J comprise a deflection roller 53, by way of which a substrate feeding or substrate transport direction can be modified. The band-type substrate 5 is initially provided on a coil, which can be unwound by the coiler 55 of the module A. Here, an initial substrate transport direction towards the adjacently located module B is substantially horizontal.

In the adjacently located module B the band-shaped substrate 5 is deflected upwardly by way of the deflection roller 53. Accordingly, the next module C is located on top of module B. The module D is located on top of module C. The module E is located on top of module D. This way, there is provided a module arrangement 11 comprising the modules B, C, D, E, through which the substrate 5 is transported in an upward or vertical direction. The module arrangement 11 forms or constitutes a column of individual modules for transporting and/or treating the substrate 5.

In module E the substrate 5 is deflected again towards a horizontal direction. The substrate 5 is transported or fed through the module F and is then deflected downwardly in module G. Below module G there is arranged the module H and further the module I, before the substrate 5 enters the transportation module J below module I, where the substrate 5 is deflected again in horizontal direction. The module arrangement 12 comprising the modules G, H, I, J defines a vertically downward column of modules whereas the module arrangement 11 defines a vertically upright arrangement or assembly of modules B, C, D, E.

Once the substrate 5 is deflected in module J it is further provided and transported to termination module K, where the band-shaped substrate 5 is coiled by the further coiler 55.

A surface treatment of the substrate 5 takes places in the numerous treatment modules C, D, H, I, wherein the surface of the substrate 5 is heated, pretreated and/or coated, e.g. by physical vapor deposition. The vertical arrangement of the numerous treatment modules C, D, H, I is beneficial for a two-sided simultaneous treatment or coating of the surface of the substrate 5. Here, an effect of gravity is equal on both sides of the substrate 5.

Moreover, by way of a vertically extending column of individual modules B, C, D, E or G, H, I, J and hence of a respective module arrangement 11, 12 the overall footprint and the installation space of the vacuum coating system 10 can be reduced to a minimum.

In Fig. 2 there is illustrated another configuration of a vacuum coating system 10. Here, the vacuum coating system 10 comprises a single consecutive horizontal arrangement of modules A, B, C, D and F. The modules A, F represent end or termination modules each of which being equipped with a coiler 55, 55. The respective transportation unit 50 located inside or provided by these modules A, F may be further provided by a tensioning roller 54. The coating system 10 may comprise a free span type of a transportation unit 50. It may comprise a roll-to-roll arrangement, wherein the substrate 5 is suspended in the deposition area, e.g. in any one of the modules B, C, D or E, without any physical or mechanical contact, e.g. to rollers.

Between the modules A and F there is arranged a row of modules B, C, D and E. The modules B, C, D and E are all implemented as so-called treatment modules. They are all equipped with a type of a treatment unit 60 by way of which a surface treatment of the substrate 5 can be provided in principle. The substrate outlets of the module A is connected with a substrate inlet of the module B. A substrate outlet of the module B is connected with a substrate inlet of the module C. A substrate outlet of the module C is connected with a substrate inlet of the module D. A substrate outlet of the module D is connected with a substrate inlet of the module E. A substrate outlet of the module E connected with a substrate inlet of the module F.

As illustrated in Fig. 2 with the modules B, C, D and E the substrate inlet and the substrate outlets are opposite to each other, thereby providing a rather straight and undeflected substrate transportation from the module A towards the module F.

The module B of Fig. 2 is provided with a plasma source 64, e.g. for a pretreatment of the substrate 5. The module C is provided with a magnetron 63, e.g. for a sputter-based treatment of the surface of the substrate 5. The module D is provided with a first evaporator 62, e.g. for depositing a first evaporation material and the subsequent module E may be provided with another evaporator 62', e.g. for depositing another evaporation material onto the surface of the substrate 5.

The configuration of the vacuum coating system 10 as shown in Fig. 2 may be particularly configured for a single-sided treatment. However, the configuration of the vacuum coating system 10 according to Fig. 2 may be also suitable for a double-sided treatment of the substrate 5. The configuration as shown in Fig. 1 is particularly dedicated for a double-sided treatment of the substrate 5. There, the modules C, D, H, I, which are implemented as substrate treatment modules and which are hence provided with a treatment unit 60 each comprise a twofold arrangement of the respective treatment unit. Hence, the module C comprises two individual plasma sources 64, which are provided on opposite sides of the substrate 5. The module D comprises two magnetrons 63, each of which provided on opposite sides of the substrate 5. In the same way also the modules H and I each comprise two evaporators 62, 62' on opposite sides of the substrate 5.

As will be explained below the individual modules, e.g. a first module 20 and a second module 40 are particularly configured for a reconfiguration of the entire vacuum coating system 10 so as to facilitate to adapt the vacuum coating system to varying demands of a particular coating or surface treatment process of the substrate 5.

The end or termination modules A, K of Fig. 1 may be closed and/or sealed by a closure 51, which is vacuum tight. The same may apply to the modules A and F of the configuration according to Fig. 2. Accordingly, the interior of the individual modules A-K and A-F may be subject to a comparatively low pressure, e.g. a vacuum pressure, which is obtained by a respective connection or coupling with a vacuum pump or several vacuum pumps. In some examples, the interior of all modules A - K or A - F as illustrated in Figs. 1 and 2 are flow connected in terms of providing a constant reduced pressure level in all chambers as formed by the individual modules or module housings.

Alternatively, the coiler 55 may be replaced by an airlock, by way of which an endless band-type substrate can be transferred from atmospheric pressure outside the modules A-K, A-F to a vacuum pressure inside the mutually interconnected modules A-K or A-F.

In the following, terms like a first module and a second module only represent different modules of the vacuum coating system. Even though the first module is primarily described to comprise a substrate treatment unit and the second module is primarily described to comprise a substrate transportation unit such assignments are rather arbitrary and nonlimiting as to the usability of the first and second modules are module housings.

Typically and as it is apparent from the configurations as shown in Fig. 1 and Fig. 2 each module is provided with one of a substrate transportation unit 5 and/or with one of a substrate treatment unit 60. By way of example the module H of Fig. 1 can be regarded as a first module 20". The first module 20" comprises a first module housing 21 with a first substrate inlet 22 and a first substrate outlet 23.

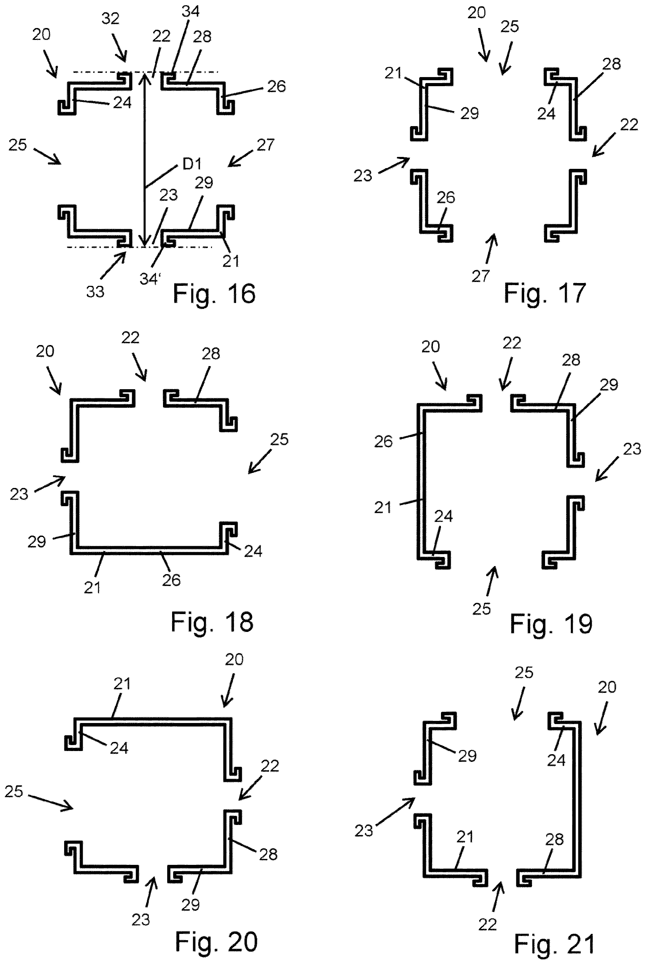

As particularly illustrated in Fig. 16 in greater detail the first module housing 21 may be of a somewhat rectangular or cuboid shape. The first module housing 21 comprises a first sidewall 24 provided with a first through recess 25 and further comprises a second sidewall 26 with a second through recess 27. The first module housing 21 further comprises a third sidewall 28 provided with a first substrate inlet 22 and further comprises a fourth sidewall 29 provided with a first substrate outlet 23. In operation the first module 20 receives the substrate 5 through the first substrate inlet 22. The substrate 5 extends through the first module housing 21 and leaves the first module housing 21 through the first substrate outlet 23. The first module housing 21 may be exclusively equippable or may be exclusively equipped with one or two treatment units 60. With the example of a module H the first module 20" may be provided with two evaporators 62 in the through recesses 25, 27.

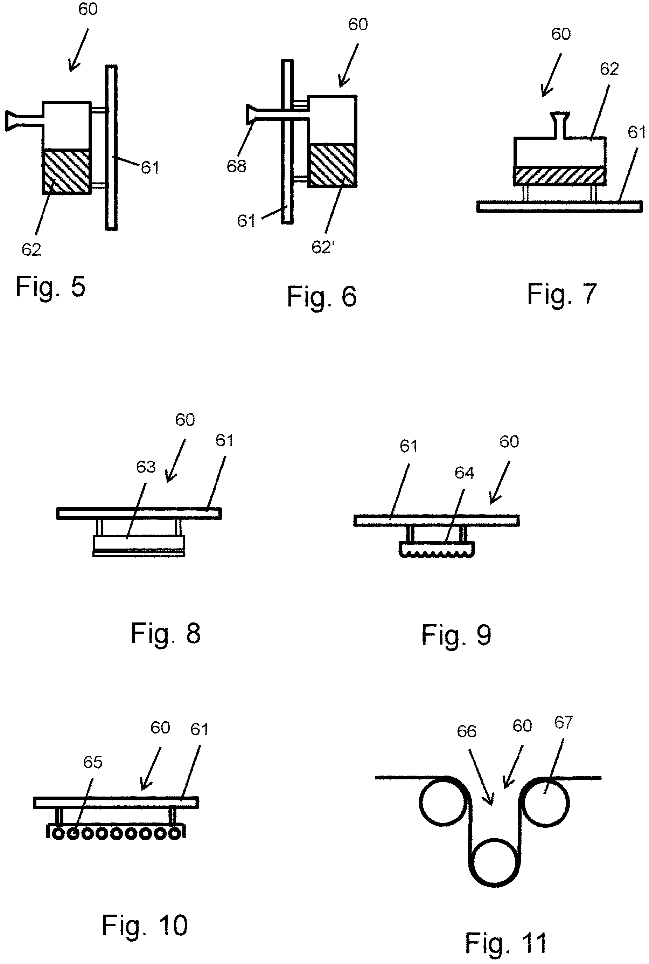

The evaporators 62, e.g. shown in greater detail in Figs. 5 - 7 may each comprise a lid 61 which is sized and configured to close and/or to seal the through opening 25, 27 in the first and second sidewalls 24, 26. With the example of Fig. 6 the evaporator 62 or at least a portion thereof is configured for arrangement outside the module housing 21, 41. Here, only a nozzle 68 extends through the lid 61 and enters the interior of the respective module housing 21, 41. Both evaporators 62 as shown in Figs. 5 and 6 are configured exclusively for such module housing 21, through which the substrate 5 is transported in a vertical direction.

The evaporator 62 as shown in Fig. 7 is configured for use with module housings 21, 41, through which the substrate 5 is transported horizontally.

The cooling unit 66 as shown in Fig. 11 may be provided with a number of rollers, which are actively or passively cooled, thereby inducing a respective cooling effect on the substrate 5.

As further illustrated in Fig. 16 the first substrate inlet 22 is provided with a first connecting structure 32, e.g. implemented as a flange 34. The oppositely located first substrate outlet 23 may be provided with a counter connecting structure 33, e.g. implemented as a respective counter flange 34'.

In some examples the first mechanical connecting structure 32 may be complementary shaped to the first mechanical counter connecting structure 33. In this way, equally shaped module housings 21, 21' or module housings 21, 21' of the same or common type can be arranged and connected adjacent to each other, such that the first mechanical connecting structure 32 of another first module housing 21' is connectable with the first mechanical counter connecting structure 33 of the first module housing 21.

In this way and as illustrated in the configuration of Fig. 1 the substrate inlet of the module 20"', hence the substrate inlet of module I can be connected with the substrate outlet of the module H, hence of the module 20". In the illustrated example the modules 20", 20‴ comprise equally shaped first module housings 21. Hence, the first mechanical connecting structure 32 as provided at the substrate inlet 22 of the module 20‴ is connectable with the first mechanical counter connecting structure 33 as provided at the substrate outlet 23 of the module 20".

In the same or like manner also the example of a second module 40, e.g. equipped with a second module housing 41 comprises first and second sidewalls 44, 46 as well as third and fourth sidewalls 45, 47. The third sidewall 45 is provided with a second substrate inlet 42. The fourth sidewall 47 is provided with a second substrate outlet 43. The second substrate inlet 42 is provided with a second mechanical connecting structure 48 and the second substrate outlet 43 is provided with a second mechanical counter connecting structure 49. Also here, the second mechanical connecting structure 48 may be complementary shaped to the second mechanical counter connecting structure 49. The second mechanical counter connecting structure 49 may be complementary shaped also to the first mechanical connecting structure 32 of the first module housing 21. Likewise, the second mechanical connecting structure 48 may be complementary shaped and may correspond with the first mechanical counter connecting structure 33 of the first module housing 21.

The numerous examples of a first module housing 21 as shown in Fig. 16-21 each comprise a first substrate inlet 22 and a first substrate outlet 23. With the examples of Figs. 16 and 17 the substrate inlets 22 and the substrate outlets 23 are located on opposite sides of the first module housing 21. With the examples of Figs. 18-21, the substrate inlets 22 and the substrate outlets 23 are located on or in sidewalls that are arranged adjacent to each other. Here, the first module housing 21 may not only be configured to receive or to provide a housing for a substrate treatment unit 60 but also provides installation space for a substrate transportation unit 50, in particular for a deflection roller 53 by way of which the orientation or direction of the feeding or transport of the substrate 5 through the respective first module housing 21 can be modified accordingly.

With all examples as shown in Fig. 16-21 the module housing 21 comprises at least one through recess 25, 27, which is configured to receive a substrate treatment unit 60, e.g. one of the substrate treatment units as shown in any of the Figs. 5-11. Most, if not all of the substrate treatment units 60 as shown in Figs. 5-10 are provided with a lid 61, which is sized and shaped to close and/or to seal the through recess 25, 27 of the respective first module housing 21. The through recess 25 may be provided with a kind of a flange structure thereby facilitating a detachable and hence reconfigurable fastening and/or arranging of the various substrate treatment units 60 in or to the respective through recesses 25, 27.

The substrate treatment unit 60, e.g. in form of an evaporator 62, a magnetron 63, a plasma source 64, a heating unit 65 or a cooling unit 66, may be detachably fastenable to the module housing 21 through the lid 61. Insofar, the lid 61 may provide a support and/or or a fastening structure for detachably fastening and/or for arranging the substrate treatment unit 60 inside the interior of the module housing 21.

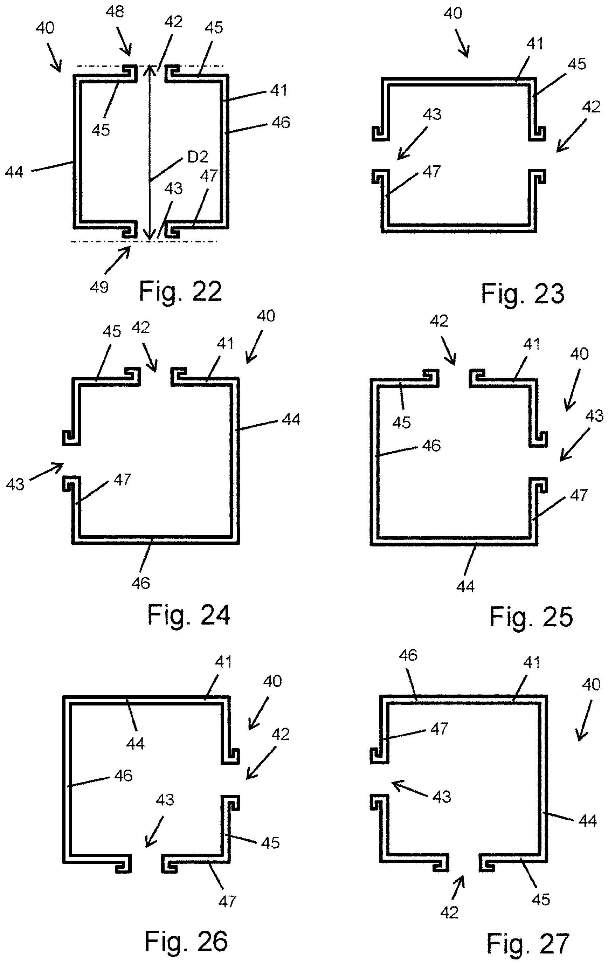

In Figs. 22-27 there are illustrated numerous examples of a second module 40, which comprises a second module housing 41, which, like the first module housing 21, is equally provided with a second substrate inlet 42 and a second substrate outlet 43. In the configuration of examples as shown in Figs. 22 and 23 the substrate inlet 42 is opposite the substrate outlet 43. In the other configurations or examples as shown in Figs. 24-27 the sidewalls of the second module housing 41, which are equipped with a substrate inlet 42 and with a substrate outlet 43 are adjacently arranged and are hence located next to each other.

With the examples of Figs. 24-27 the respective second module 40 and hence the second module housing 41 is typically equipped with a substrate transportation unit 50, e.g. comprising a deflection roller 53 by way of which the substrate feeding or substrate transportation direction can be modified inside the respective module housing 41.

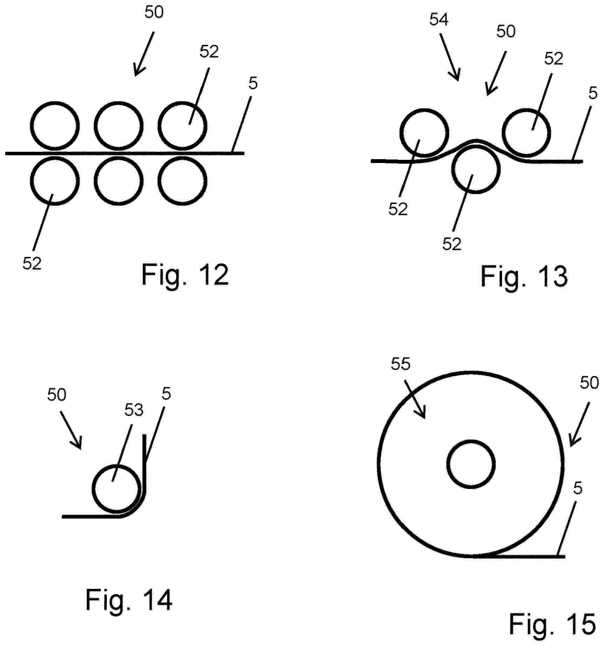

In Fig. 12-15 numerous examples of a transportation unit 50 configured for arrangement inside the first module housing 21 and/or inside the second module housing 41 are illustrated. The transportation unit 50 according to Fig. 12 comprises numerous transport roller 52, via which the substrate 5 can be transported in or along a predefined transport or feeding direction.

In Fig. 13 there is illustrated a transportation unit 50 comprising at least one or numerous tensioning rollers 54. Here, numerous transport rollers 52 are arranged in a staggered or slightly offset position with regard to a surface normal of the substrate 5. In this way, there can be induced a longitudinal or transverse tension across the planar-shaped band-type substrate 5.

In Fig. 14 there is shown an example of a transportation unit 50 comprising a deflection roller 53. By way of the deflection roller 53 the transport direction of the substrate 5 through the respective first or second module housings 21, 41 can be modified accordingly.

In Fig. 15 there is shown another example of a transportation unit 50 comprising a coiler 55, which is implemented to unwind or to wind the band-shaped substrate 5 from or to coil as e.g. shown with the final modules A, K of Fig. 1

In some examples and for a rather easy and straight forward reconfiguration of the entire vacuum coating system 10 it is particularly intended that the size, e.g. the effective distance between substrate inlet 22, 42 and substrate outlets 23, 43 of individual modules 20, 40 is follows a well-defined grid dimension or modular dimension.

In the illustration of Fig. 16, a first effective distance D1 between the first substrate inlet 22 and the first substrate outlet 23 of a first module 20 is indicated. A respective second effective distance D2 between the second substrate inlet 42 and the second substrate outlet 43 is shown with an example of a second module housing 41 in Fig. 22. For a universal and rather flexible reconfiguration of the vacuum coating system 10 it is either intended that the second effective distance D2 is identical or equivalent to the first effective distance D1. Alternatively, the first effective distance D1 is identical or equivalent to an integer multiple n of a fraction f of the second effective distance D. Here, f is one of: 1/2, 1/3, 1/4, 1/5, 1/6, 1/7 or 1/8 and n is one of: 1, 2, 3, 4, 5, 6, 7, 8, 9, 10, 11, 12, 13, 14, 15 or 16.

This way and in order to obtain a different configuration of a vacuum coating system 10 as e.g. shown in Fig. 1 e.g. towards a configuration according to Fig. 2 it may be only necessary to exchange one or some of the modules equipped with one of a transportation unit and a substrate treatment unit with one or some other modules equipped with another substrate transportation unit and another substrate treatment unit. Alternatively, it is conceivable to maintain the structure of mutually interconnected first and second and further optional module housing and to replace one of a substrate treatment unit and a substrate transportation unit of at least one of modules by another substate treatment unit or transportation unit.

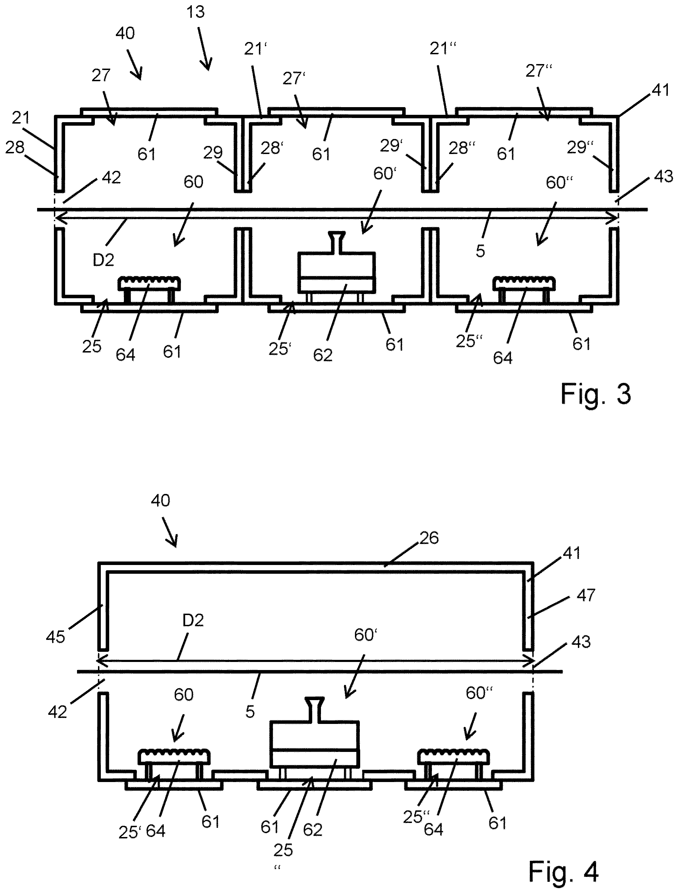

In the example of Fig. 16 the first effective distance D1 is substantially identical to the second effective distance D2 of the second module housing 41 as e.g. shown in Fig. 22. However, with the example of Fig. 3, the second effective distance D2 of a second module housing 41 maybe three times as large as the first effective distance D1. With the example of Fig. 4, the second effective distance D2 maybe twice as large as the first effective distance D1.

Since the first effective distance D1 is identical or equivalent to n/f of the second effective distance D2 a number n of modules or module housing with a second effective distance D2 can be replaced by a number f of first module housings each of which comprising a first effective distance D1.

In Fig. 3 there is illustrated an example of a module arrangement 13, e.g. made of an assembly of three individual module housings 21, 21', 21". The module arrangement 13 comprises a row of substantially equal first module housings 21, 21', 21". The individual module housings 21, 21', 21" are implemented in a way as illustrated in Fig. 16 but rotated by about 90°. They comprise first and second sidewalls 24, 26, each of which provided with a through recess 25, 27, which is closed by a lid 61. As illustrated, only a lower through recess 25 as provided in the first sidewall 24 is provided with a treatment unit 60. The first module housing 21 is provided with a plasma source 64. The second module housing 21' is provided with an evaporator 62 and the third module housing 21" is provided with another plasma source 64.

In the example of Fig. 3 the third sidewall 28 of the module housing 21 comprises a substrate inlet 42. An oppositely located for the sidewall 29 is directly connected with a third sidewall 28' of the following or subsequent and adjacently located module housing 21'. Opposite the third sidewall 28' the second module housing 21' comprises a fourth sidewall 29', which is likewise connected with the third sidewall 28"of the third module housing 21" Opposite to the third sidewall 28" the second module housing 21 "comprises a fourth sidewall 2", which is provided with the substrate outlet 43.

The arrangement of the three individual first module housings 21, 21', 21" forms or constitutes a module arrangement 13, which may represent a second module 40 of which may constitute a second module housing 41.

The effective distance D2 between the substrate inlet 42 and the substrate outlet 43 may be e.g. three times the effective distance D1.

In Fig. 4, there is shown another example of a second module 40 with an another second module housing 41. Here, the module 40 may be somewhat equally equipped with substrate treatment unit 60, 60', 60" as described above in connection with Fig. 3. However, in Fig. 4 the module housing 41 comprises a unitary body with a first sidewall 24 provided with numerous through recesses 25, 25' and 25" and an oppositely located second sidewall 26, which is void of any recesses or through openings. The third sidewall 45 extending between one end of the oppositely located sidewalls 24 and 26 is provided with the substrate inlet 42. A fourth sidewall 47 provided with the substrate outlet 43 is located opposite the third sidewall 45. Also here, the substrate inlet 42 is separated from the substrate outlet 43 by a second effective distance D2, which is equivalent to the first effective distance D1 and wherein the first effective distance D1 is equivalent to one of an integer multiple n/f with n and f being integer numbers as mentioned above.

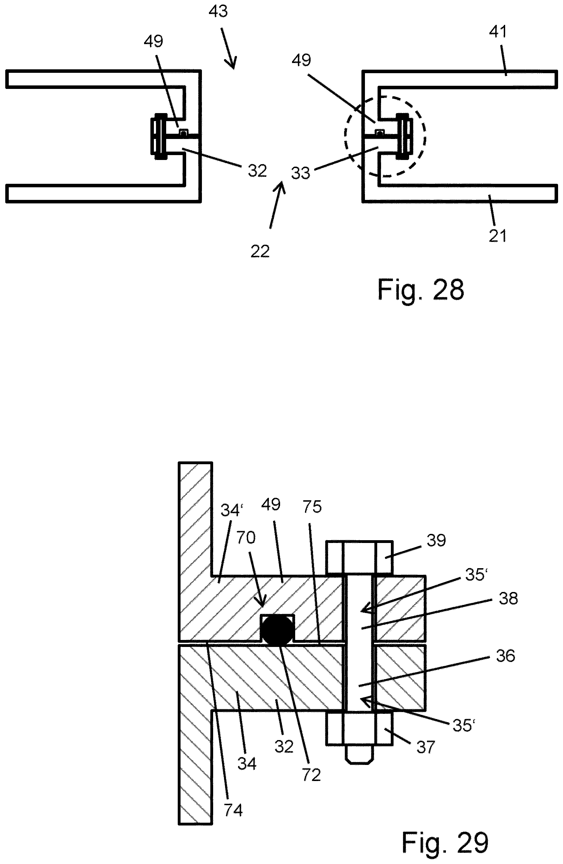

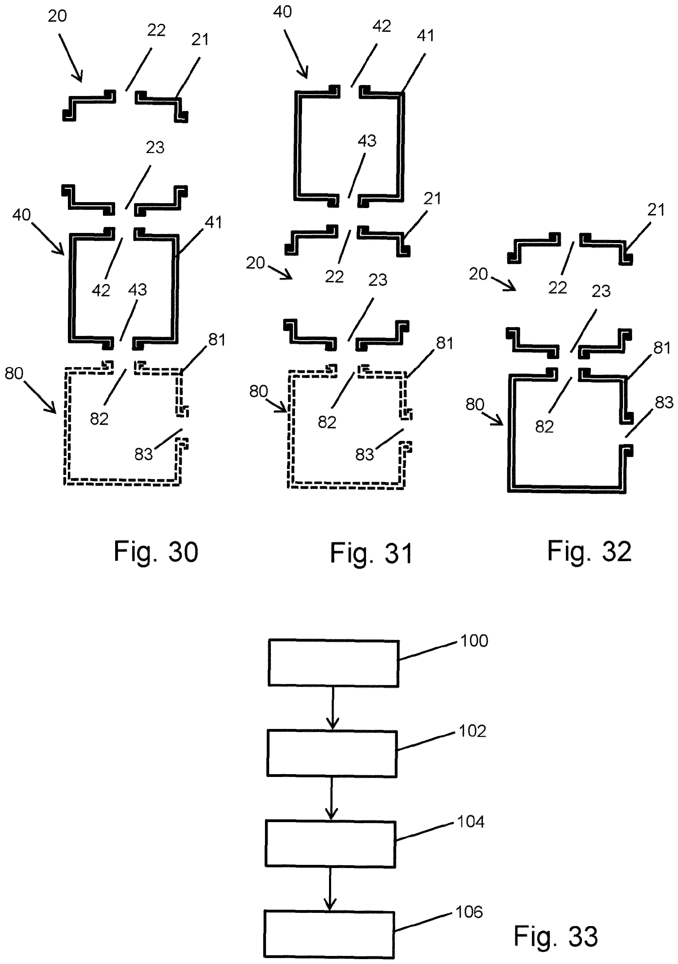

In Figs. 30-32 there are illustrated three different operating configurations of the vacuum coating system. In a first operating configuration as shown in Fig. 30 the first module 20 is connected with a second module 40. In particular, a first substrate outlet 23 is connected with a second substrate inlet 42. Only optionally and when there should be present a third module 80 the second substrate outlet 43 of the second module 40 may be connected with a third substrate inlet 82 of the third module housing 81. As will be explained in greater detail with regard to Figs. 28 and 29 the substrate inlets 22, 42, 82 and the substrate outlets 23, 43, 83 are provided with mutually corresponding or complementary shaped mechanical connecting structures 32, 48 and mechanical counter connecting structures 33, 49, which support and allow for a variable connection of the individual modules 20, 40, 80.

Accordingly and in a second operating configuration as shown in Fig. 31 the positions of the first module 20 and the second module 40 have interchanged. The second substrate outlet 43 of the second module 40 or module housing 41 is connected with the first substrate inlet 22 of the first module housing 21. Only optionally, and when the third module 80 should be present with the second operating configuration, the first substrate outlet 23 of the first module housing 21 is connected with the third substrate inlet 82 of the third module 80 or module housing 81.

Such a reconfiguration is possible since the first and second substrate inlets 22, 42 as well as the first and second substrate outlets 23, 43 are provided with common mechanical connecting structures 32, 48 and common mechanical counter connecting structures 33, 49.

In a third operating configuration as illustrated in Fig. 32 the arrangement as shown in Fig. 30 comprises three individual modules 20, 40, 80. Here, and in the first configuration the module 80 with the third module housing 81 is connected with the second module 40. The second module 40 is located and arranged between the first module 20 and the third module 80. For transferring the vacuum coating system 10 and hence the arrangement of individual modules from the first operating configuration as shown in Fig. 30 into the third operating configuration as shown in Fig. 32 the mutual connections between first, second and third modules 20, 40, 80 are temporarily deactivated or released and the second module 40 is removed.

For transferring the arrangement of modules into the third operating configuration as shown in Fig. 32 the first substrate outlet 23 of the first module housing 21 is connected with the third substrate inlet 82 of the third module housing 81 of the third module 80. In the presently illustrated examples the third module 80 comprises a third substrate outlet 83 in a sidewall that is adjacent to the sidewall, which sidewall is provided with the third substrate inlet 82. Here, the third module 80 may be equipped with a transportation unit 50, such as a deflection roller 53.

The variable interconnectivity of the individual modules 20, 40, 80 and module housings 22, 41, 81 is provided by standardized mechanical connecting structures and mechanical counter connecting structures, respectively.

One example of a mutual connection e.g. between first and second housings 20, 40 in accordance to the second operating configuration of Fig. 31 is shown in Fig. 28. The first module housing 21 is arranged below the second module housing 41. Accordingly, the first substrate inlet 22 is connected with the second substrate outlet 43. The first substrate inlet 22 is provided with a first mechanical connecting structure 32. The second substrate outlet 43 is provided with a second mechanical counter connecting structure 49 at the second substrate outlet 43.

The first mechanical connecting structure 32 and the second mechanical counter connecting structure 49 comprise a radially extending flange 34, extending substantially perpendicular to the direction of substrate transport. In detail, the first mechanical connecting structure 32 comprises a flange 34 and the second mechanical counter connecting structure 49 comprises a complementary shaped counter flange 34' as illustrated in Fig. 29.

The flange 34 is provided with a planar-shaped sealing or flange surface 75. The complementary shaped counter flange 34' is provided with a sealing or flange surface 74. One of the sealing surfaces or flange surfaces 74, 75 is provided with a groove 70, in which is located a seal 72, such as an O-Ring. The groove 70 and the entire flange may comprise a closed structures in a circumferential direction. The seal 72 may slightly protrude from the respective sealing surface 74 and may be subject to an elastic deformation as the sealing surfaces 74, 75 are pressed together.

For mutually connecting the flange 34 with the counter flange 34', the flange 34 and the counter flange 34' are each provided with a through opening 35, 35', which through openings 35, 35' are aligned in longitudinal direction when the sealing or flange surfaces 74, 75 and hence the substrate inlet 22 is aligned with the substrate outlet 43. The channel formed by the aligned through openings 35, 35' is sized to receive a fastening element 36 by way of which the flange 34 and the counter flange 34' can be pressed together to provide a sealed engagement between the connecting structure 32 and the counter connecting structure 49. In the presently illustrated example the fastening element 36 comprises a longitudinal extending bolt 38, which is provided with a radially widened head on one longitudinal end and which is threadedly engageable with a nut 37 on an opposite longitudinal end. The head 39 and the nut 37 are located on opposite sides of the flange 34 and the counter flange 34' that face away from each other.

In some examples the flange 34 and the counter flange 34' extend outwardly from the sidewalls or sidewall sections of the respective module housings 21, 41. Here, the fastening element 36 may be accessible from outside the modules 20, 40. In other examples the connecting structures 32, 42 and the counter connecting structures 33, 49 are located inside the interior of the respective module housings 21, 41.

In such examples the fastening elements 36 may not be accessible from outside the respective module housings 21, 41. Here, they may be only and exclusively accessible from the inside of the respective modules 20, 40.

It should be noted that the presently illustrated example of connecting structures 32, 48 and counter connecting structures 33, 49 is in no way limiting for mutually interconnecting first, second and third module housings 21, 41, 81. There may be numerous different ways of how to detachably interconnected various module housings in the region of respective substrate inlets or substrate outlets.

In the flowchart of Fig. 33 there is illustrated a method of reconfiguring a vacuum coating system 10 as described herein. In step 100 there is at least provided a first module housing 21 and a second module housing 41. In step 102 there are provided at least one substrate transportation unit 50 and a substrate treatment unit 60. In step 104 the substrate transportation unit 50 is interchangeably or detachably arranged in one of the first module housing 21 and the second module housing 41 and the substrate treatment unit 60 is interchangeably or detachably arranged in the other one of the first module housing 21 and the second module housing 41. Also, the first and the second module housings 21, 41 may be mutually interconnected. By way of example, a first substrate outlet 23 of the first module housing 21 may be connected with a second substrate inlet 42 of the second module housing 41 thereby interconnecting the first and second module housings 21, 41.

In a subsequent step 106 and if a reconfiguration of the vacuum coating system 10 should be required or desired, e.g. a substrate treatment unit 60 as e.g. located in the second module housing 41 may be replaced by another substrate treatment unit 60'.

Alternatively, the order of the arrangement of the modules 20, 40 as such may be subject to a modification. The reconfiguration as executed in step 106 then include a rearrangement of the module housings 21, 41. Accordingly, the order of arrangement of first and second module housings 21, 41 may be swapped or interchanged, such that e.g. the first module housing 21 proceeds the second module housing with respect to the substrate transportation direction. Then and contrary to the initial configuration as obtained in step 104, the second substrate outlet 43 of the second module housing 41 may be connected with the first substrate inlet 22 of the first module housing 21.

### Reference Numbers

- 5: substrate
- 10: vacuum coating system
- 11: module arrangement
- 12: module arrangement
- 13: module arrangement
- 20: module
- 21: module housing
- 22: substrate inlet
- 23: substrate outlet
- 24: sidewall
- 25: through recess
- 26: sidewall
- 27: through recess
- 28: sidewall
- 29: sidewall
- 32: connecting structure
- 33: counter connecting structure
- 34: flange
- 35: through opening
- 36: fastening element
- 37: nut
- 38: bolt
- 39: head
- 40: module
- 41: module housing
- 42: substrate inlet
- 43: substrate outlet
- 44: sidewall
- 45: sidewall
- 46: sidewall
- 47: sidewall
- 48: connecting structure
- 49: counter connecting structure
- 50: transportation unit
- 51: closure
- 52: transport roller
- 53: deflection roller
- 54: tensioning roller
- 55: coiler
- 60: treatment unit
- 61: lid
- 62: evaporator
- 63: magnetron
- 64: plasma source
- 65: heating unit
- 66: cooling unit
- 67: roller
- 68: nozzle
- 70: groove
- 72: seal
- 74: sealing surface
- 75: sealing surface
- 80: module
- 81: module housing
- 82: substrate inlet
- 83: substrate outlet

## Claims

1. A vacuum coating system (10) for coating a band-type substrate (5), the vacuum coating system (10) comprising:
- a first module (20) comprising a first module housing (21), the first module housing (21) comprising at least one of a first substrate inlet (22) and a first substrate outlet (23),
a second module (40) comprising a second module housing (41), the second module housing (41) comprising at least one of a second substrate inlet (42) and a second substrate outlet (43),
- a substrate transportation unit (50) provided in one of the first module housing (21) and the second module housing (41) and
- a substrate treatment unit (60) provided in the other one of the first module housing (21) and the second module housing (41),
- wherein at least one of the substrate transportation unit (50) and the substrate treatment unit (70) is interchangeably arranged in one of the first module housing (21) and the second module housing (41), or
- wherein the first module (20) and the second module (40) are interchangeably connectable via at least one of the first and second substrate inlets (22, 42) and at least one of the first and second substrate outlets (23, 43), respectively.

2. The vacuum coating system (10) according to claim 1, wherein the vacuum coating system (10) is transferable between a first operating configuration and at least one of a second operating configuration and a third operating configuration,
- wherein in the first operating configuration, the first substrate outlet (23) is directly or indirectly connected with the second substrate inlet (42),
- wherein in the second operating configuration, the second substrate outlet (43) is directly or indirectly connected with the first substrate inlet (22), and
- wherein in the third operating configuration, the first substrate outlet (23) is directly connected with a third substrate inlet (82) of a third substrate housing (81) of a third module (80), wherein in the first operating configuration the third substrate inlet (82) is directly or indirectly connected with the second substrate outlet (83).

3. The vacuum coating system (10) according to claim 1 or 2, wherein the first module housing (21) comprises the first substrate inlet (22) and the first substrate outlet (23) and wherein a first effective distance (D1) between the first substrate inlet (22) and the first substrate outlet (23) is identical or equivalent to one of:
- a second effective distance (D2) between the second substrate inlet (42) and the second substrate outlet (43) of the second module housing (41),
- and an integer multiple n of a fraction f of the second effective distance (D2), wherein f is one of: 1/2, 1/3, 1/4, 1/5, 1/6, 1/7 or 1/8 and wherein n is one of: 1, 2, 3, 4, 5, 6, 7, 8, 9, 10, 11, 12, 13, 14, 15 or 16.

4. The vacuum coating system (10) according to any one of the preceding claims, wherein at least one of the first module housing (21) and the second module housing (41) comprises a first sidewall (24) with a first through recess (25) extending through the first sidewall (24) and configured to receive a first substrate treatment unit (60) therethrough.

5. The vacuum coating system (10) according to any one of the preceding claims, wherein at least one of the first module housing (21) and the second module housing (41) comprises a second sidewall (26) with a second through recess (27) extending through the second sidewall (26) and configured to receive a second substrate treatment unit (60') therethrough.

6. The vacuum coating system (10) according to claims 4 and 5, wherein one of the first module housing (21) and the second module housing (41) comprises the first sidewall (24) with the first through recess (25) and the second sidewall (26) with the second through recess (27), wherein the first sidewall (24) is opposite to the second side wall (26) and/or wherein the first through recess (25) is opposite the second through recess (27).

7. The vacuum coating system (10) according to any one of the preceding claims 4-6, wherein the substrate treatment unit (60) comprises a lid (61) configured to close and/or to seal at least one of the first through recess (25) and the second through recess (27).

8. The vacuum coating system (10) according to any one of the preceding claims, wherein the substrate treatment unit (60) comprises one of an evaporator (62), a magnetron (63), a plasma source (64), a heating unit (65) and a cooling unit (66).

9. The vacuum coating system (10) according to any one of the preceding claims, wherein one of the first module (20) and the second module (40) is interchangeably provided with a first substrate treatment unit (60) and wherein the first substrate treatment unit (60) is replaceable by a second substrate treatment unit (60').

10. The vacuum coating system (10) according to any one of the preceding claims, wherein the substrate transportation unit (50) comprises one of a transport roller (52), a deflection roller (53), a tensioning roller (54) and a coiler (55).

11. The vacuum coating system (10) according to any one of the preceding claims, wherein at least one of the first module housing (21) and the second module housing (41) comprises a third sidewall (28, 45) and a fourth sidewall (29, 47), wherein the third sidewall (28, 45) is provided with one of the first substrate inlet (22) and the second substrate inlet (42) and wherein the fourth sidewall (29, 47) is provided with one of the first substrate outlet (23) and the second substrate outlet (43).

12. The vacuum coating system (10) according to claim 11, wherein the third side wall (28, 45) is opposite to the fourth sidewall (29, 47), and/or wherein the first substrate inlet (22) is opposite to the first substrate outlet (23) and/or wherein the second substrate inlet (42) is opposite to the second substrate outlet (43).

13. The vacuum coating system (10) according to claim 11, wherein the third sidewall (28, 45) is adjacent to or adjoins the fourth side wall (29, 47) and wherein at least one of the first substrate inlet (22) and the second substrate inlet (42) extends at a predefined angle relative to the first substrate outlet (23) and the second substrate outlet (43) of the same module housing (21, 41).

14. The vacuum coating system (10) according to any one of the preceding claims, wherein the first module housing (21) comprises a first mechanical connecting structure (32) at the first substrate inlet (22) and a first mechanical counter connecting structure (33) at the first substrate outlet (23) and wherein the second module housing (41) comprises a second mechanical connecting structure (48) at the second substrate inlet (42) and a second mechanical counter connecting structure (49) at the second substrate outlet (43) and wherein the first mechanical connecting structure (32) is complementary shaped to at least one of the first mechanical counter connecting structure (33), the second mechanical connecting structure (48) and the second mechanical counter connecting structure (49).

15. A method of configuring a vacuum coating system (10) according to any one of the preceding claims, the method comprising the steps of:
- providing of the first module housing (21) and the second module housing (41),
- providing a substrate transportation unit (50) and a substrate treatment unit (70), and comprising at least one of the following steps of:
i) exchangeable arranging the substrate transportation unit (50) in one of the first module housing (21) and the second module housing (41) and interchangeably arranging the substrate treatment unit (60) in the other one of the first module housing (21) and the second module housing (41), or
ii) interchangeably connecting the first module (20) and the second module (40) via at least one of the first and second substrate inlets (22, 42) and at least one of the first and second substrate outlets (23, 43), respectively.
